# EUROPEAN PATENT SPECIFICATION

(11) **EP 0 602 623 B1**
(45) Date of publication and mention of the grant of the patent: **18.03.1998**
(21) Application number: 93120208.9
(22) Date of filing: 15.12.1993
(51) Int. Cl.: G11C 11/22, G09G 3/36

(54) **Liquid crystal display device with memory fonction**
Flüssigkristallanzeigeanordnung mit Speicherfunktion
Dispositif d'affichage à cristaux liquides avec fonctions de mémoire

(30) Priority: 18.12.1992 US 995403
(43) Date of publication of application: 22.06.1994
(73) Proprietor: NCR International, Inc., Dayton, Ohio 45479 (US)
(72) Inventor: Baur, Peter F., D-86156 Augsburg (DE)
(74) Representative: Irish, Vivien Elizabeth

(56) References cited:
- EP-A- 0 374 372
- EP-A- 0 378 249
- GB-A- 2 069 739
- GB-A- 2 255 844
- US-A- 3 972 040

## Description

This invention relates to liquid crystal display devices.

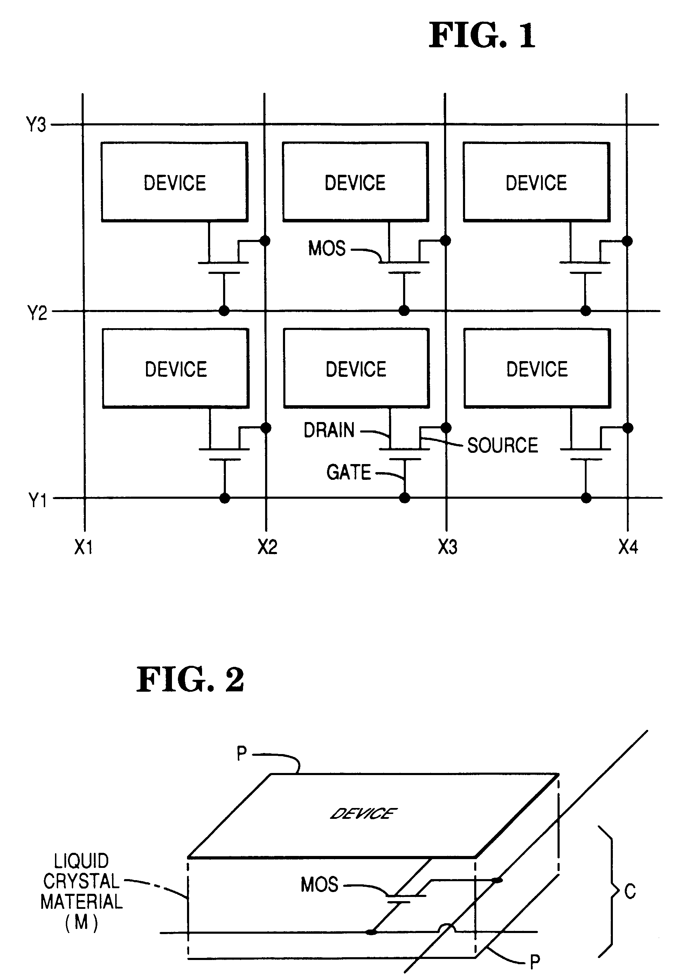

Figure 1 illustrates six pixels of a Liquid-Crystal Display (LCD). The boxes labelled DEVICE represent the LCD elements, or pixels. The transistors labelled MOS turn the respective DEVICE elements on and off.

The operation of the LCD can be explained, in a very simplified manner, as follows. In Figure 2, liquid crystal material M is contained between the plates P of a capacitor C. (Each box in Figure 1 labeled "DEVICE" represents one of the plates.)

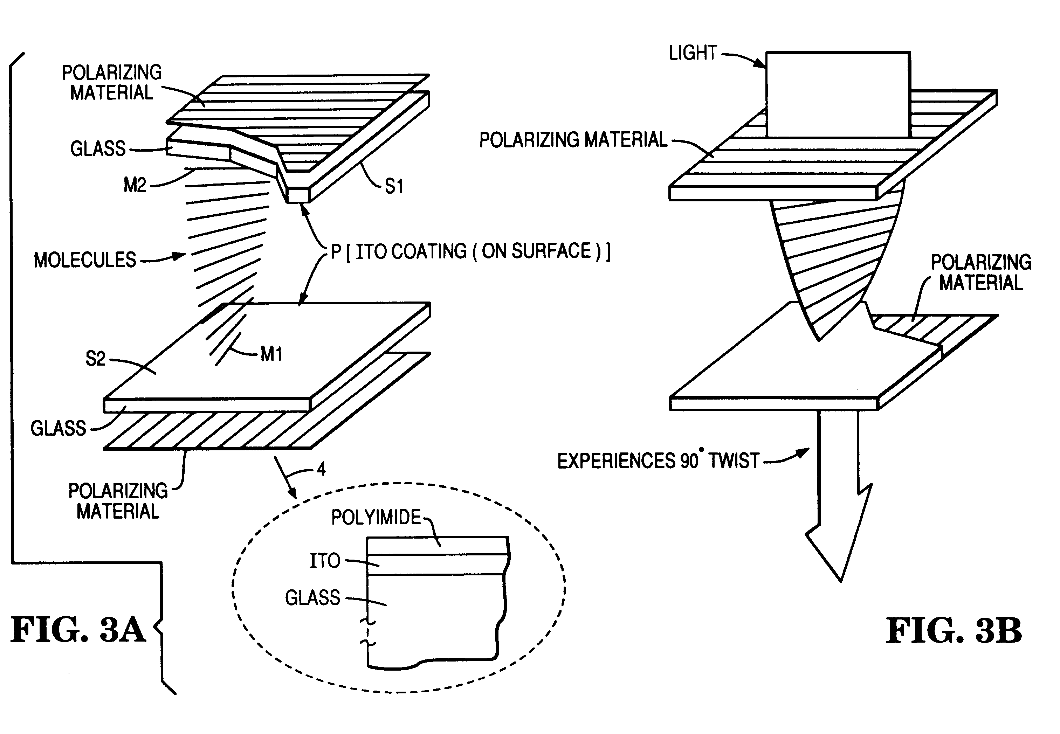

Each plate P in Figure 2 actually takes the form of a thin coating of Indium Tin Oxide, ITO, on GLASS, shown in Figure 3A. Each coating of ITO, in turn, bears a coating of polyimide, as indicated in the insert 4. The polyimide has been rubbed, during manufacture, in a unidirectional manner. The rubbed polyimide causes the molecules of the liquid crystal material, which are adjacent to the polyimide, to align with the rubbed polyimide layer. For example, molecules M1 and M2 align as shown.

The polyimide layers are arranged such that molecules M1 and M2 are perpendicular, as shown. The molecules located in the bulk of the liquid crystal try to align themselves with M1 and M2, but, because M1 and M2 are perpendicular, the other molecules form a helix which bridges between M1 and M2. Because of the helix, the display is termed "twisted" in the art.

Polarizing filters are affixed to each sheet of GLASS, as indicated. When incoming LIGHT enters, as shown in Figure 3B, the polarization of the LIGHT follows the twisted molecules, and the LIGHT undergoes a continuous 90-degree twist, as shown, and exits through the bottom polarizing filter. The device, or pixel, appears bright, because of the exiting LIGHT.

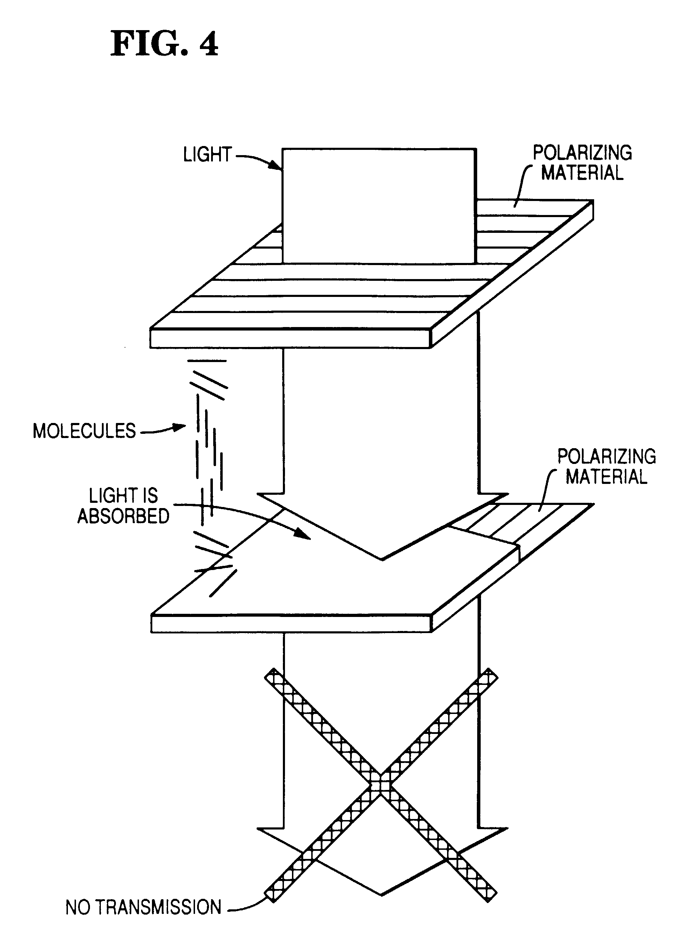

However, when a small voltage (such as 3- 5 volts) is applied between the ITO plates, the gradual twist of the molecules shown in Figure 3A is disturbed, as shown in Figure 4. The helix no longer exists. The light is no longer twisted as it travels, but is blocked by the lower polarizing filter, as shown. The pixel appears dark.

In an actual LCD, the number of pixels is quite large. For example, the display of a small computer can contain an array of 480 x 640 pixels, giving a total of 307,200 pixels. With such a large number of pixels, the charge described in connection with Figure 4 is applied to each MOS in multiplex fashion, because it is not feasible to connect the plates of 307,200 pixels to 307,200 controlling switches.

Further, in multiplexing, the charge is not applied directly to the ITO plates as described above. Instead, there exists an external Random-Access Memory (termed video RAM, or V-RAM) which contains a memory cell for each pixel. A video controller (not shown) writes the data into the video RAM. Then, other circuitry (not shown) reads each cell in the V-RAM, and applies the proper charge to the corresponding MOS. The MOS delivers current to the capacitor in its pixel, creating a field which aligns the liquid crystal molecules as shown in Figure 4.

The video display is "refreshed" periodically. In one type of refreshing, a controller (not shown) reads each memory cell in V-RAM, and applies the proper charge to each MOS of each pixel, based on the memory cell's contents.

Figure 1 is somewhat exaggerated for clarity: the Metal Oxide Semiconductor Transistors (MOS) actually occupy proportionately less space than shown, and the DISPLAY occupies greater space. The reason that the DISPLAY element occupies proportionately more space is to allocate maximum area to the information-producing component, namely, the DISPLAY element.

The provision of video RAM is a cost factor which adds to the expense to producing an operative LCD device. Various LCD display systems which do not require use of video RAM are known. In GB-A-2069739 and EP-A-0378249, LCD display arrangements are described in which the image data can be stored directly in display pixels with refreshing of the pixels being performed periodically and automatically on the basis of their data content rather than on the basis of externally stored data. US-A-3972040 also discloses a display system in which the display acts as its own memory for the purpose of refreshed operation.

It is the object of the present invention to provide a liquid crystal display device which is of low cost.

Therefore, according to the present invention, there is provided a liquid crystal display device, including a plurality of pixels each including liquid crystal material contained between a pair of electrodes forming a capacitor, each pixel being associated with a respective switching device, addressing means adapted to address said switching devices so that video data may be stored on the associated capacitors without the provision of a separate video memory for said video data and refreshing means adapted to refresh the capacitors in said pixels, in dependence on their data content, characterized in that said refreshing means is adapted to periodically sense a signal from each pixel and to ascertain which, if any, of N different thresholds the signal exceeds and in response, to apply a corresponding one of N charges to the capacitor of the pixel only if said signal exceeds one of said thresholds.

It will be appreciated that a liquid display device according to the invention enables the achievement of low cost by virtue of the omission of a separate video memory.

Embodiments of the invention will now be described by way of example, with reference to the accompanying drawings, in which:-

Figure 1 illustrates a six-element liquid-crystal display (LCD).

Figure 2 illustrates a single element of the LCD.

Figure 3A illustrates a liquid crystal pixel.

Figure 3B illustrates light being twisted by the pixel of Figure 3A.

Figure 4 illustrates blockage of light caused by application of a voltage to the pixel of Figure 3A.

Figure 5 illustrates controlling circuitry associated with the LCD.

Figure 5A illustrates the substitution of an LCD array for a dynamic random-access memory in a video memory system.

Figure 6 is a simplified illustration of apparatus which changes the polarity of the LCD elements.

Figure 7 illustrates the spatial orientation of the memory data, as compared with the orientation of the actual pixels in the LCD.

Figure 8 illustrates how one form of the invention can be used as video RAM for an external video monitor.

Figure 8A illustrates a system for refreshing the MOS gates when the gates store one of multiple voltage levels, rather than one of binary levels.

Figure 9 illustrates a portable computer and an auxiliary video display.

Figure 10 illustrates a system for writing data to pixels using a light pen.

Briefly, the invention enables a separate video RAM (V-RAM) for a video display to be eliminated. The function of the video RAM memory cells is adopted by the pixel capacitances of the display itself.

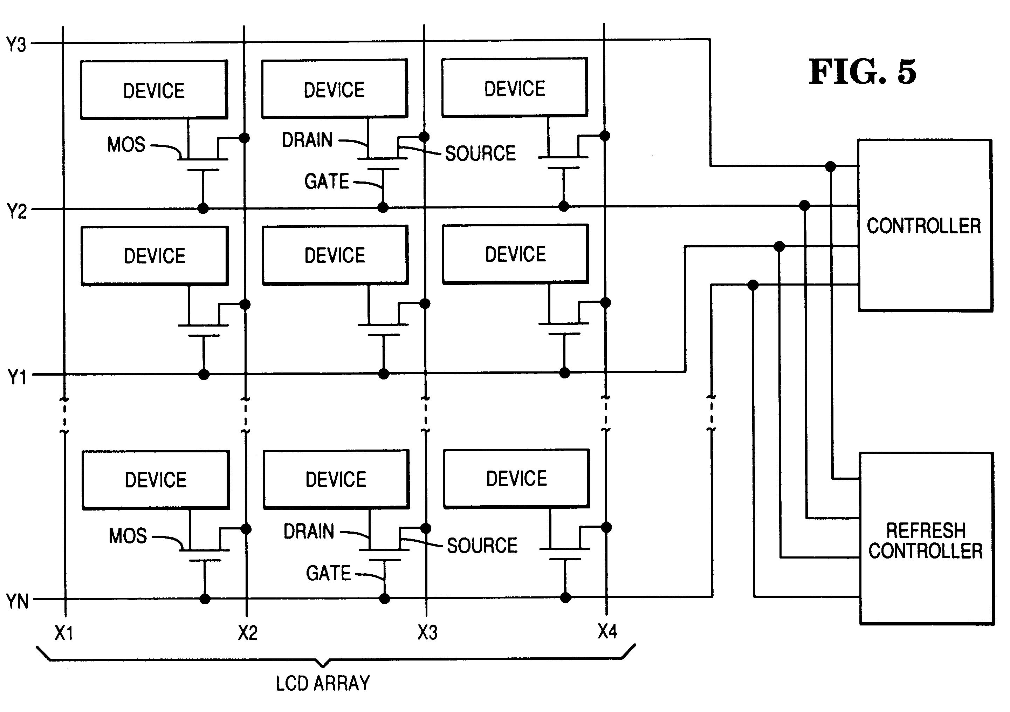

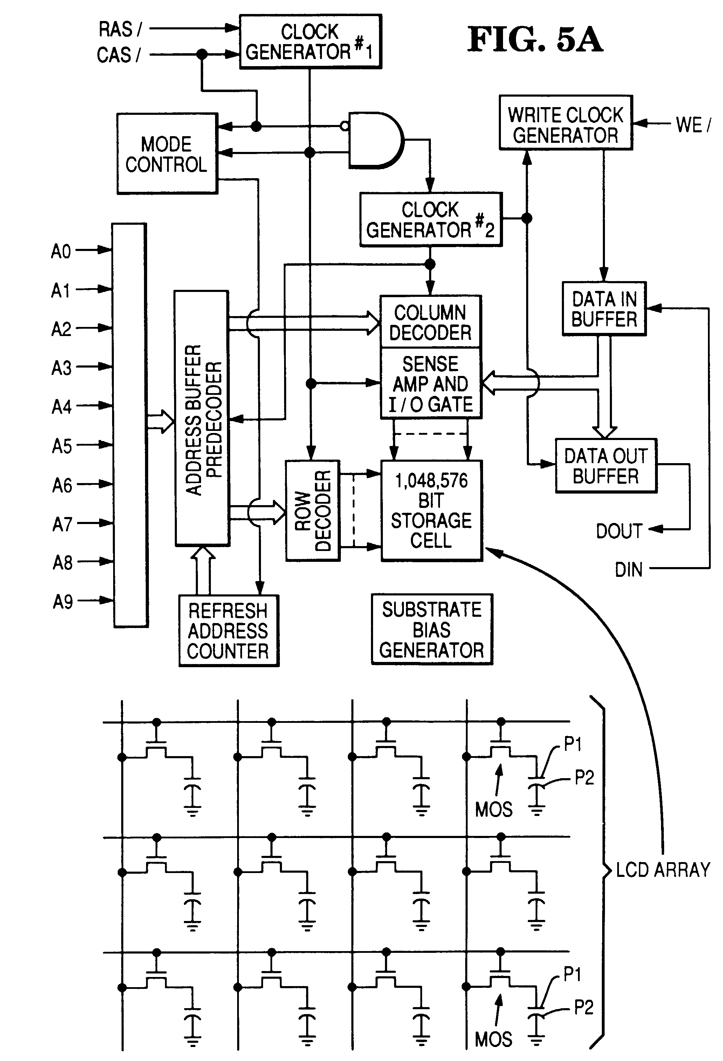

That is, the schematic layout of a Thin-Film Transistor (TFT) LCD matrix is virtually the same as that of the memory storage cells in a Dynamic Random Access Memory (D-RAM) matrix. Consequently, the capacitors (such as the ITO plates in Figure 3A) of the LCD display can be substituted for the STORAGE CELLs of the DRAM of Figure 5A. (These latter STORAGE CELLS, in the prior art, generally take the form of the gate capacitances of MOS transistors.)

Thus, the LCD provides both a display function and a V-RAM function.

When an image is to be displayed, a CONTROLLER in Figure 5 applies a charge to the gates of the proper MOS transistors, thereby applying a charge to the plates (not shown in Figure 5) adjacent the liquid crystal material. This charge is used as the V-RAM data: it is sustained by refreshing, and is rewritten when the pixel darkness is to change.

It should be noted that two elements contribute to the capacitance which holds the data. One is the plates P in Figure 3A, which act as a capacitor. The second is the drain capacitance of the MOS, which makes a small contribution to the total capacitance. The combined effect of these two capacitances acts as the memory element. However, for convenience, the plates P in Figure 3A are assumed to store the charge.

After the charge is applied to the MOS transistors in the display, a REFRESH circuit periodically performs a refresh sequence on the MOS transistors.

During the sequence, the stored charge on the plates P in Figure 3A of each pixel is first measured. Next, the measured charge is compared with a threshold. If the measured charge exceeds the threshold, indicating that a ONE has been previously stored, then the plates P are recharged, by applying a new charge of predetermined size. If the measured charge falls below the threshold, indicating that a ZERO has been previously stored, then no action is taken.

Refreshing arrays of MOS transistors is known in the art. There are numerous different approaches.

The read/write operations of the pixels in the display must be timed so that they do not conflict with refreshing. Such synchronization is known in the art: many prior-art V-RAMs are of the dynamic type, which require refreshing. Synchronization of the read/write cycles with the refresh cycles in V-RAMs has been perfected.

In a Liquid Crystal Display, if one of the plates P in Figure 3A, is always given the same charge polarity, such as positive, in order to make the pixel dark as in Figure 4, then, eventually, the liquid crystals become permanently skewed in the direction dictated by that charge. The crystals do not fully relax to their rest position after the charge is removed, and the pixel becomes degraded. Further, the pixel electrodes (ie, the ITO films in Figure 3A) become dissolved electrochemically.

In order to mitigate this problem, it is known in the art to periodically change the polarity applied to the plates P in an LCD display. For example, during some time intervals, when a pixel is to be darkened (that is, the pixel is to attain the state shown in Figure 4) positive charge is applied to one of the plates P in Figure 3A. During other time intervals, when a pixel is to be darkened, a negative charge is applied to the plate. In either case, the charge orients the crystals as shown in Figure 4 (although possibly in opposite directions), so that light is absorbed.

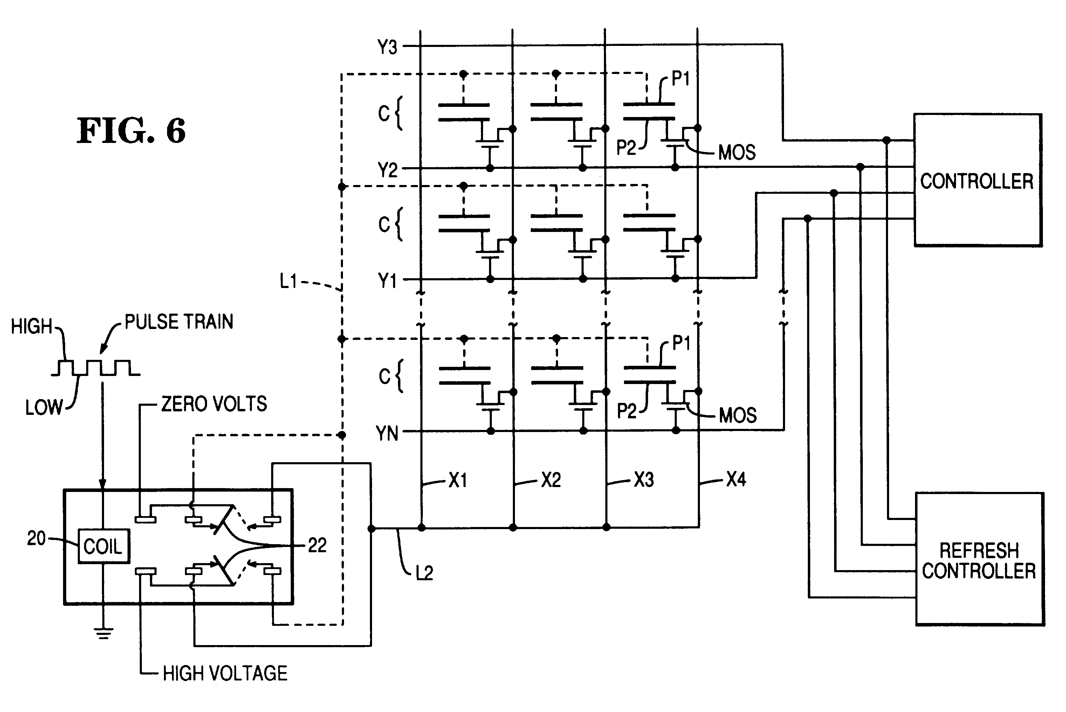

One apparatus for performing this periodic reversal is schematically shown in Figure 6. A double-pole, double-throw (DPDT) relay periodically switches the polarity of lines L1 and L2 in response to the PULSE TRAIN applied to the relay's coil 20. The polarity reversal causes the plates P1 and P2 to acquire reverse polarities when the MOS of the respective pixel is turned on.

For example, one sequence is the following:
-- First, a LOW pulse in the PULSE TRAIN is applied to DPDT. The LOW pulse does not energize coil 20, so the reeds 22 are in the positions indicated by the solid lines. L1 (the phantom lines) are at ZERO VOLTS and L2 (solid lines) are at HIGH VOLTAGE (such as about 3 to 20 volts). Now, when an MOS is driven into conduction by the CONTROLLER, its associated plate P2 becomes positive with respect to P1.
-- Next, a HIGH pulse is applied to the DPDT. The reeds 22 are pulled to the phantom positions. L1 is brought to a HIGH VOLTAGE, and L2 is brought to ZERO VOLTS. Now, when an MOS conducts, its associated plate P2 becomes negative with respect to P1.
-- The cycle repeats.

Each polarity reversal will discharge each capacitor C, and then recharge it with opposite polarity. The DPDT is shown for ease of explanation. The polarity switching will most likely be done with a solid-state device.

The polarity reversal will be sufficiently fast that flicker will not occur in the display. If flicker does occur, it may be desirable to reverse different groups of pixels at different times. For example, even-numbered pixels may be reversed at time T1. Odd-numbered pixels may be reversed at T2, followed by the re-reversal of the even pixels at T3. This type of reversal introduces a type of interleaving.

The REFRESH CONTROLLER must accommodate the polarity reversal during refreshing. A simple way is to perform refreshing as usual, but not during reversal.

Another approach is to reverse both (a) the measured polarities ascribed to the plates P and (b) the applied voltage when refreshing is called for, both in synchrony with the PULSE TRAIN of Figure 6. For example, when a LOW pulse is applied to the DPDT, then, when writing to a pixel occurs, a HIGH voltage is applied to plates P2, and ZERO volts to P1. Thus, at this time, P2 should be assigned a positive polarity when sensed by the REFRESH CONTROLLER. If refreshing is called for, P2 should be given a HIGH voltage.

Conversely, when a HIGH pulse is applied to the DPDT, then, when writing to a pixel occurs, ZERO voltage is applied to plates P2, and a HIGH voltage to P1. At this time, P1 should be assigned a positive polarity during sensing. If refreshing is called for, P1 should be given a high voltage.

Consequently, if P1 is sensed as HIGH during refresh, it will be refreshed with a HIGH voltage. If P2 is sensed HIGH, it will be refreshed with a HIGH voltage.

Other approaches are possible.

It should be noted that the video data is physically interspersed among the pixels. The data is located on the plates P of the pixels, shown in Figures 2, 3A, and 6. The data has a spatial arrangement which corresponds to the image appearing on the display. That is, if each packet of charge stored on each MOS were visualized as a point of light, the collective points would display the image.

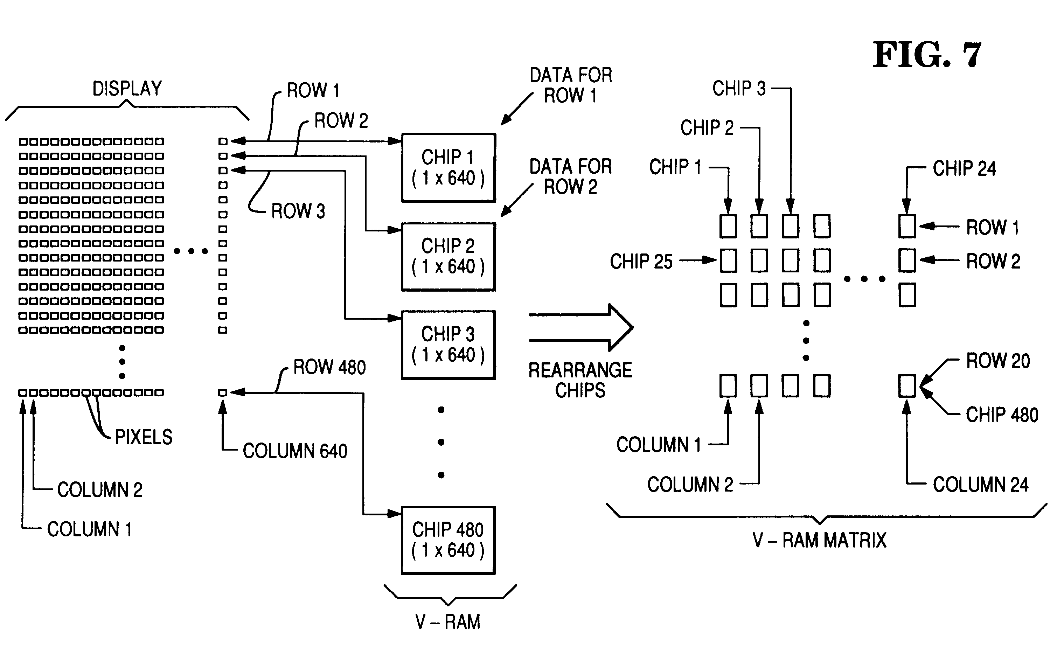

In contrast, the data stored in a prior art video RAM does not necessarily have a physical arrangement which corresponds to the image displayed. As an extreme example, in the case of a 480 x 640 display, the data for each row of pixels can be stored in a single RAM chip of capacity of 640 x 1 bits, as shown in Figure 7. There are 480 such chips. The chips can be arranged in a matrix which is 20 rows x 24 columns, as shown.

With this arrangement, the data for the address (row 1, column 1) of the display will be located at address #1 in chip number 1, which is in the position shown. The data for the address (row 2, column 2) of the display will be located at address #2 in chip number 2, which is located in the position shown, and so on.

The physical arrangement of the data within the chips is not related to the physical arrangement of the pixels in the display. If each packet of charge stored in the video RAM were to be visualized as a point of light, the collective points would not represent the image.

Further, even if the data in the video RAM were arranged to correspond with the pixel locations, the stored data would not be positioned to the same scale as the pixels. That is, if the 480 x 640 display measured 122.0 x 162.0 mm (4.8 x 6.4 inches), the pixels would be 0.01 inch apart. However, the packets of charge stored in the video RAM would be separated by much smaller distances, on the order of microns, not hundredths of an inch. Restated, the video RAM would not occupy nearly a space of 122.0 x 162.0 mm (4.8 x 6.4 inches).

It will be appreciated that there is no necessity that the voltage levels which represent ONEs and ZEROs stored in the LCD display be the same as the levels used in system memory, cache memory, or other types of memory, or even in the logic in the computer itself. In fact, the voltage levels will probably be different, because different laws of physics dictate the voltage level needed to darken a pixel, as compared with that needed to operate the switching circuitry in the computer.

LCDs are not restricted to the ON-OFF type discussed above. They can exhibit degrees of grey: applying progressively more charge to the plates P of Figure 3 causes the electric field to progressively increase, causing progressively more alignment of the liquid crystals. The pixel becomes progressively brighter as the field increases.

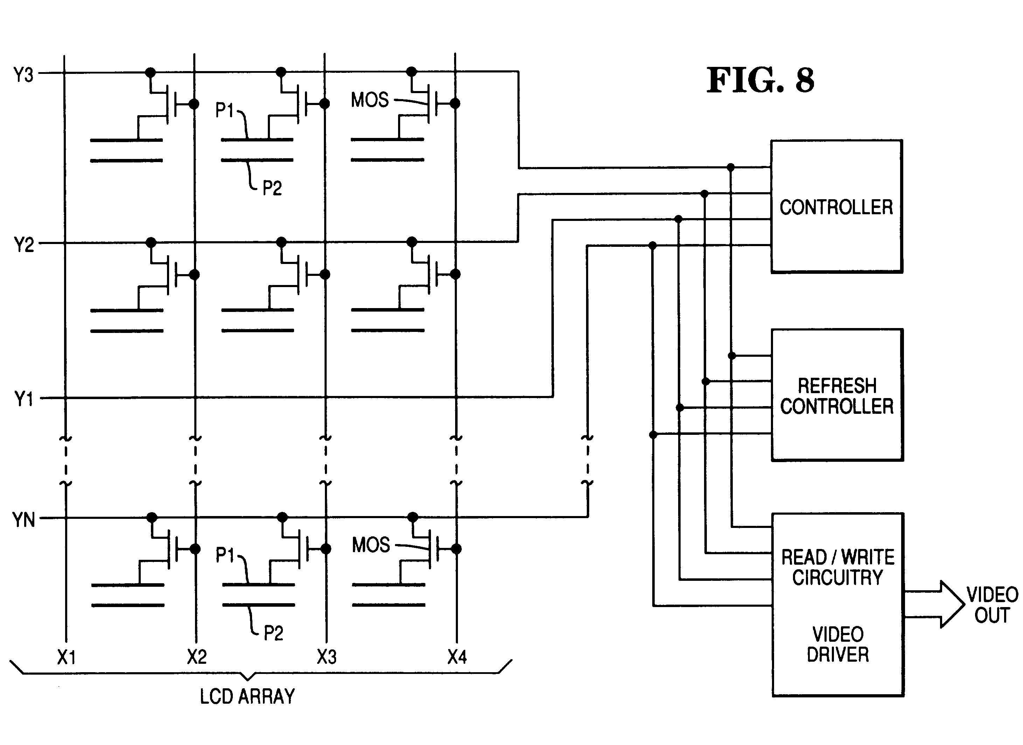

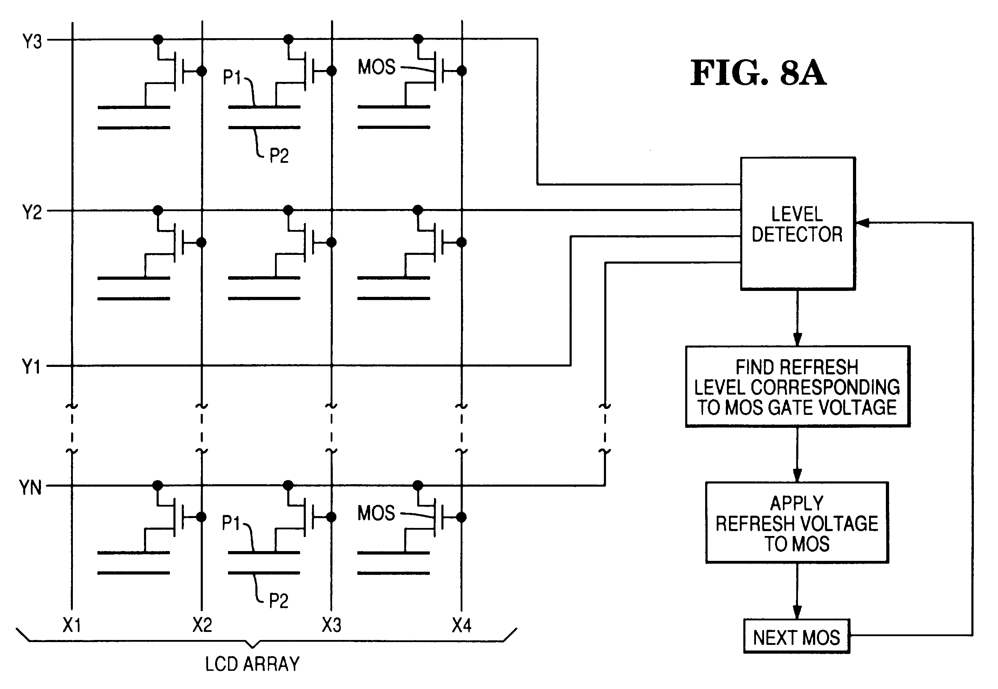

To refresh a system of this type, the level of charge on the gate of each MOS is sensed, and its gate charge is refreshed accordingly, as indicated by Figure 8A.

For example, assume eight levels of grey. During refresh, the a LEVEL DETECTOR in Figure 8A senses the voltage of each plate P, and classifies it into one of eight levels. In response, a corresponding voltage is applied to the MOS connected to the plates. The corresponding voltage is higher than the actual voltage sensed, in order to compensate for the discharge which will occur prior to the next refresh. Figure 8A illustrates the sequence.

This arrangement may be characterized as an "multi-level" V-RAM: each gate voltage is initially one of eight possible levels, although it decays as time progresses. However, the eight possible levels are not stored as a three-bit binary number, but as an analog voltage on the gate capacitance.

The term "multi-level" should not be misunderstood. This voltage is similar, in one respect, to the voltage stored in a "digital" memory cell: both voltages decay with time.

However, the analog voltage is different because it stores multiple bits of information. (In the example above, three bits are stored.) In contrast, a "digital" memory cell stores a single bit.

In the refreshing sequence described above, refreshing is done only when the voltage of a storage cell (ie, the plates P in Figures such as 3A and 8) is found to be above a threshold. This above-threshold voltage is taken to indicate the presence of a charge (ie, a ONE) in the cell, which is decaying, and in need of restoration. In contrast, when the voltage detected is below the threshold, no refreshing is done, because it is assumed that a ZERO is stored, and that no decaying voltage is stored.

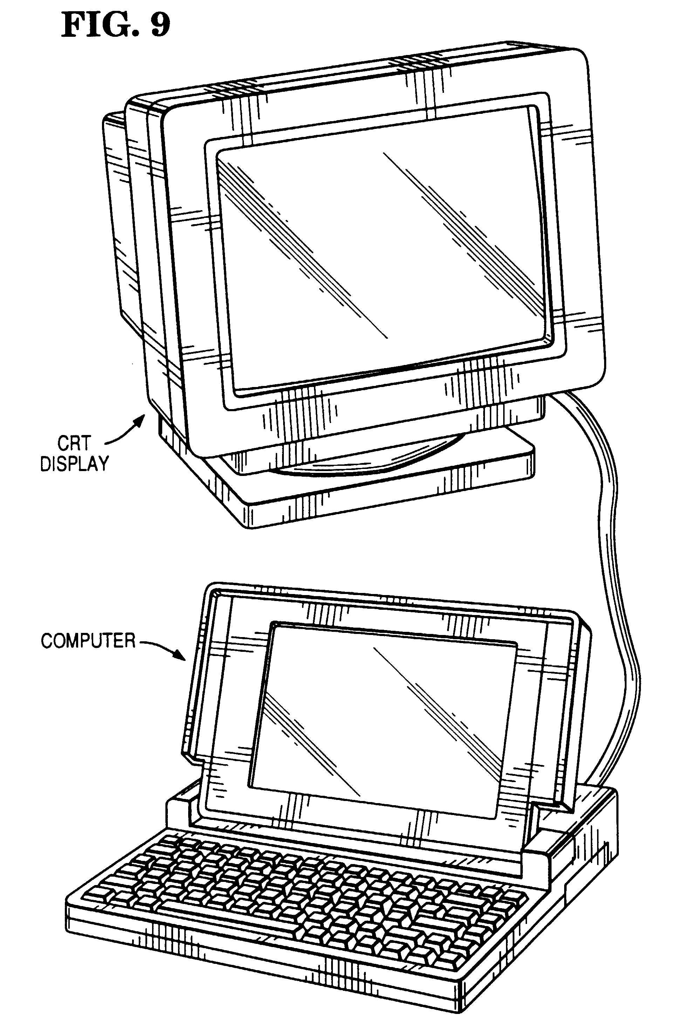

LCD's of the type under discussion are commonly used in portable computers, sometimes called "notebook" computers. These computers frequently have provision for attachment of an external Cathode Ray Tube (CRT) video monitor, as shown in Figure 9. The invention can drive such a monitor, using the apparatus shown in Figure 8.

A VIDEO DRIVER, known in the art, contains READ/WRITE CIRCUITRY, also known in the art. The VIDEO DRIVER reads the data contained on each storage cell (ie, each pixel), and generates the proper video signals on the VIDEO OUT bus for driving the monitor. If the storage cell data is of the single-bit type, then the signals on the VIDEO OUT bus will be of the monochrome type. If the storage cell data is of the multi-level type, the signals on the VIDEO OUT bus will be grey scale.

As shown in Figure 6, the invention can be characterized as a video RAM in which each RAM cell comprises a field-effect transistor, MOS, having a capacitor C connected to the source or drain of the FET.

The invention can be characterized as utilizing known RAM controllers, such as that shown in Figure 5A, with an LCD matrix substituted for the RAM storage elements.

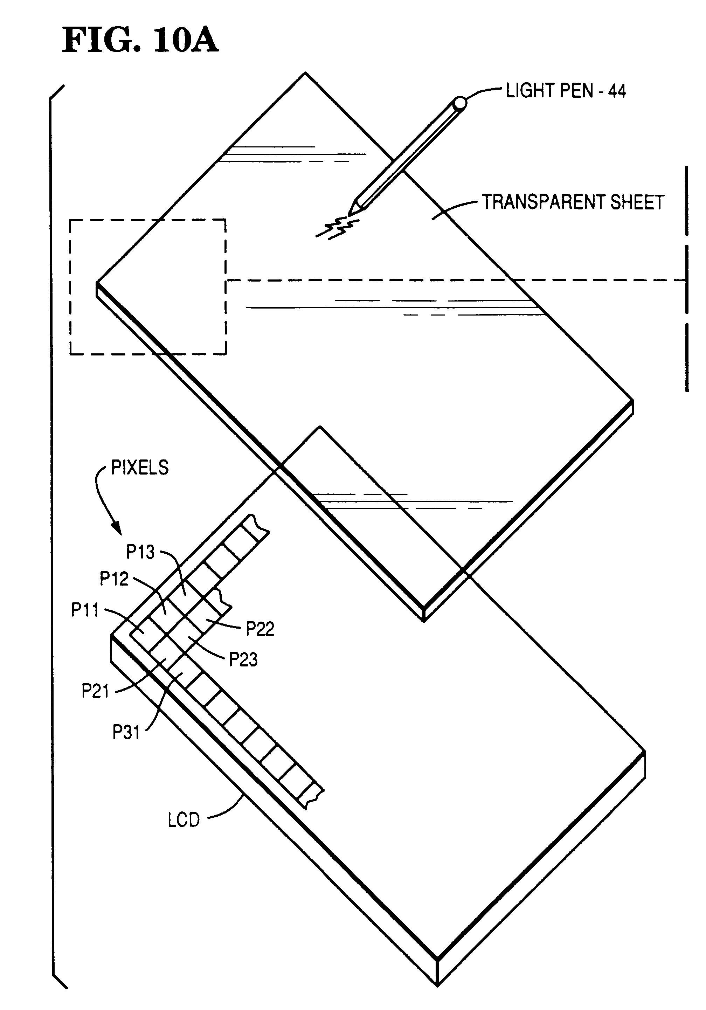

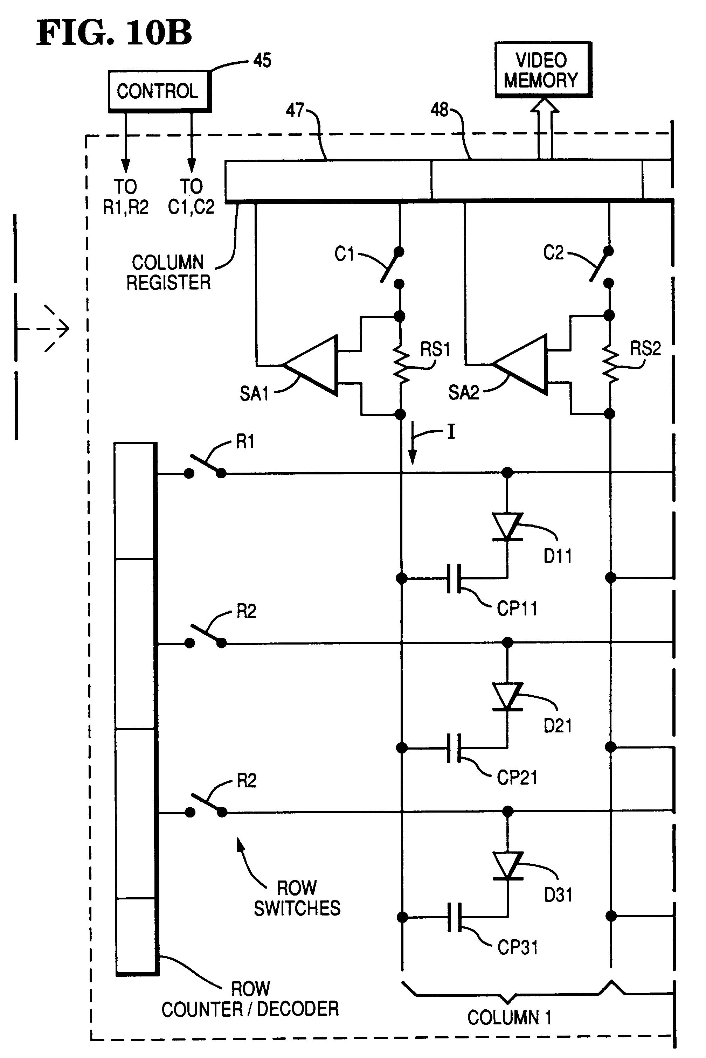

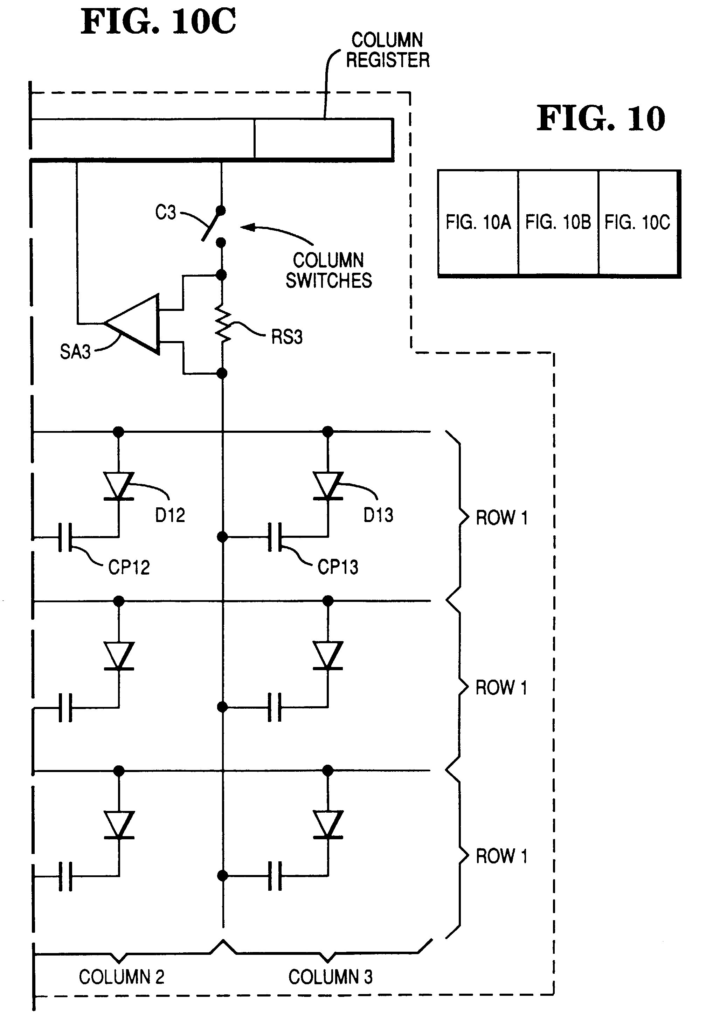

Referring now to Figs 10A to 10C, an embodiment utilizing a light pen will now be described. In Figure 10A, pixels P11, P12, etc., represent the DEVICES of Figure 1. The pixels shown in the dashed box Figure 10A are shown in greater detail in Figures 10B and 10C. Each pixel contains a photodiode and a capacitor. For example, pixel P11 in Figure 10A contains capacitor CP11 and photodiode D11 in Figure 10B.

Assume pixel P11 is to be activated. The light pen 44 in Figure 10A applies light to that pixel. Photodiode D11 in Figure 10B senses the light, and conducts a current. The current produces a voltage across sensing resistor RS1. This voltage is sensed by sense amplifier SA1, which delivers a signal to the COLUMN REGISTER, which stores the fact that pixel P11 is to be activated. A similar procedure is followed for all pixels illuminated by the light pen 44.

Each capacitor, such as CP11 in Figure 10B, acts as a storage element, as described above. The VIDEO MEMORY in Figure 10B is eliminated. Now, the light pen 44 writes data directly to V-RAM, by depositing a charge onto capacitor CP11, which is the V-RAM storage element for pixel P11.

The illumination of a photodiode, such as D11 in Figure 10B, by the light pen 44 is preferably sufficient to deliver a full charge to the capacitor CP11. In this case, the sense amplifier SA1 is not necessary: the charge deposited on CP11 will be retained by refreshing.

In some situations, as when the light pen is battery-powered and thus energy must be conserved, the light pen may deliver only sufficient charge to trigger the sense amplifier SA1, which stores the fact that pixel P11 should be activated in the COLUMN REGISTER. The light pen does not deliver full charge to CP11. Then, at a later time, such as during refresh, full charge is delivered to capacitor CP11.

## Claims

1. A liquid crystal display device, including a plurality of pixels each including liquid crystal material contained between a pair of electrodes forming a capacitor, each pixel being associated with a respective switching device, addressing means adapted to address said switching devices so that video data may be stored on the associated capacitors without the provision of a separate video memory for said video data and refreshing means adapted to refresh the capacitors in said pixels, in dependence on their data content, characterized in that said refreshing means is adapted to periodically sense a signal from each pixel and to ascertain which, if any, of N different thresholds the signal exceeds and in response, to apply a corresponding one of N charges to the capacitor of the pixel only if said signal exceeds one of said thresholds.

2. A liquid crystal display device according to claim 1, characterized in that the corresponding charge applied to the capacitor of each pixel is higher than that sensed from each pixel.

3. A liquid crystal display device according to claim 1, characterized by a photodetector associated with each pixel for delivery charge to the capacitor of the pixel in response to the application of a light signal to that pixel.

4. A liquid crystal display according to any one of the preceding claims, characterized in that a CRT display is provided and in that the video data stored in said capacitors is applied to control said CRT display.

## Patentansprüche

1. Flüssigkristall-Anzeigeeinrichtung, die eine Vielzahl von Bildpunkten, von denen jeder ein Flüssigkristallmaterial umfaßt, das zwischen einem Paar von Elektroden enthalten ist, die einen Kondensator ausbilden, wobei jedem Bildpunkt eine entsprechende Schalteinrichtung zugeordnet ist, eine Adressiereinrichtung, die zum Adressieren der Schalteinrichtungen derart ausgelegt ist, daß Bilddaten an den zugeordneten Kondensatoren ohne das Bereitstellen eines gesonderten Bildspeichers für die Bilddaten gespeichert werden können, und eine Auffrischungseinrichtung umfaßt, die zum Auffrischen der Kondensatoren in den Bildpunkten abhängig von deren Dateninhalt ausgelegt ist, dadurch gekennzeichnet, daß die Auffrischungseinrichtung zum periodischen Erfassen eines Signals von jedem Bildpunkt und zum Erfassen, welchen, falls irgendeinen, von N verschiedenen Schwellenwerten das Signal überschreitet und in Erwiderung zum Anlegen einer zugehörigen von N Ladungen an den Kondensator des Bildpunktes nur dann ausgelegt ist, falls das Signal einen der Schwellenwerte überschreitet.

2. Flüssigkristall-Anzeigeeinrichtung nach Anspruch 1, dadurch gekennzeichnet, daß die zugehörige Ladung, die an den Kondensator von jedem Bildpunkt angelegt wird, höher als die von jedem Bildpunkt erfaßte ist.

3. Flüssigkristall-Anzeigeeinrichtung nach Anspruch 1, gekennzeichnet durch einen Photodetektor, der zu jedem Bildpunkt zum Liefern einer Ladung zum Kondensator des Bildpunktes in Erwiderung auf das Anlegen eines Lichtsignals an den Bildpunkt zugeordnet ist.

4. Flüssigkristallanzeige nach einem der vorherigen Ansprüche, dadurch gekennzeichnet, daß eine CRT-Anzeigeeinrichtung bereitgestellt ist und daß die Bilddaten, die in den Kondensatoren gespeichert sind, zum Steuern der CRT-Anzeigeeinrichtung angelegt werden.

## Revendications

1. Un dispositif afficheur à cristaux liquides, comportant une pluralité de points d'image, chacun comportant un matériau cristal liquide contenu entre une paire d'électrodes formant un condensateur, chaque point d'image étant associé à un dispositif de commutation respectif, un moyen d'adressage adapté pour adresser lesdits dispositifs de commutation de façon à ce que les données vidéo puissent être mémorisées sur les condensateurs associés sans la fourniture d'une mémoire vidéo séparée pour lesdites données vidéo et un moyen de rafraîchissement adapté pour rafraîchir les condensateurs dans lesdits points d'image, en fonction de leur contenu de données, caractérisé en ce que ledit moyen de rafraîchissement est adapté pour capter périodiquement un signal de chaque point d'image et pour établir lequel, éventuellement, de N seuils différents le signal dépasse et, en réponse, pour appliquer une charge correspondante de N charges au condensateur du point d'image seulement si ledit signal dépasse l'un desdits seuils.

2. Un dispositif afficheur à cristaux liquides conformément à la revendication 1, caractérisé en ce que la charge correspondante appliquée au condensateur de chaque point d'image est plus élevée que celle lue à partir de chaque point d'image.

3. Un dispositif afficheur à cristaux liquides conformément à la revendication 1, caractérisé par un photodétecteur associé à chaque point d'image pour la fourniture d'une charge au condensateur du point d'image en réponse à l'application d'un signal lumineux à ce point d'image.

4. Un afficheur à cristaux liquides conformément à l'une quelconque des revendications précédentes, caractérisé en ce qu'un écran cathodique est fourni et en ce que les données vidéo mémorisées dans lesdits condensateurs sont appliqués pour contrôler ledit écran cathodique.
